(19) Europäisches Patentamt
European Patent Office
Office européen des brevets

(11) EP 0 553 737 B1

(12) EUROPÄISCHE PATENTSCHRIFT

(45) Veröffentlichungstag und Bekanntmachung des Hinweises auf die Patenterteilung:
**22.09.1999 Patentblatt 1999/38**

(51) Int Cl.[6]: **G03F 7/039**

(21) Anmeldenummer: **93101036.7**

(22) Anmeldetag: **23.01.1993**

# (54) Strahlungsempfindliches Gemisch

Radiation-sensitive composition

Composition sensible aux radiations

(84) Benannte Vertragsstaaten:
**BE DE FR GB IT NL**

(30) Priorität: **31.01.1992 DE 4202845**

(43) Veröffentlichungstag der Anmeldung:
**04.08.1993 Patentblatt 1993/31**

(73) Patentinhaber: **BASF Aktiengesellschaft**
**67063 Ludwigshafen (DE)**

(72) Erfinder:
- **Binder, Horst**
  **W-6840 Lampertheim (DE)**
- **Schwalm, Reinhold, Dr.**
  **D-6706 Wachenheim (DE)**
- **Funhoff, Dirk, Dr.**
  **W,6900 Heidelberg (DE)**

(56) Entgegenhaltungen:
**EP-A- 0 291 994**
**EP-A- 0 440 374**
**EP-A- 0 447 868**
**EP-A- 0 520 642**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

## Beschreibung für folgende Vertragsstaaten : DE, FR, GB

Die Erfindung betrifft positiv arbeitende strahlungsempfindliche Gemische, die ein in Wasser unlösliches Bindemittel und eine unter Einwirkung von Strahlung eine Säure bildende Verbindung, enthalten, wobei das Bindemittel bestimmte Gruppierungen enthält, die durch säurekatalytische Einwirkung verseift werden, wodurch die Alkalilöslichkeit des Gemisches erhöht wird. Diese Gemische sind sensitiv gegenüber UV-, Elektronen- und Röntgenstrahlen und eignen sich besonders als Resistmaterial.

Positiv arbeitende strahlungsempfindliche Gemische sind bekannt und besonders positiv arbeitende Resistmaterialien, die o-Chinondiazide in wäßrig-alkalisch löslichen Bindemitteln, z.B. Novolaken oder Poly(p-hydroxi-styrol)en, enthalten, werden kommerziell eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärphotoreaktion eine Spezies erzeugen, die dann unabhängig von der Strahlung eine katalytische Sekundärreaktion auslöst, sind beschrieben. So sind in der US-A 3,915,706 beispielsweise Photoinitiatoren beschrieben, die eine starke Säure erzeugen, die dann in einer Sekundärreaktion säurelabile Gruppen, wie Polyaldehydgruppierungen spalten.

Weiterhin sind strahlungsempfindliche Gemische auf Basis von säurespaltbaren Verbindungen bekannt, die als Bindemittel ein wäßrig-alkalisch lösliches Polymer sowie eine Verbindung, die photochemisch eine starke Säure bildet, und eine weitere Verbindung mit durch Säure spaltbaren Bindungen, die durch die Einwirkung der Säure ihre Löslichkeit in einem alkalischen Entwickler erhöhen, enthalten (vgl. DE-A 3 406 927). Als photochemisch eine starke Säure bildende Verbindungen werden Diazonium-, Phosphonium-, Sulfonium- und Iodonium-, sowie Halogenverbindungen genannt. Die Verwendung dieser Oniumsalze als photochemische Säurespender in Resistmaterialien ist z.B. auch aus US-A 4,491,628 bekannt. Einen Überblick über die Anwendung von Oniumsalzen in Resistmaterialien gibt Crivello in Org. Coatings and Appl. Polym. Sci., 48, p. 65-69 (1985).

Copolymere mit phenolischen und säurelabilen Gruppen, wie beispielsweise Poly-(p-hydroxistyrol-co-t-butoxicarbonyloxistyrol), sind aus J. Polym. Sci., Part A, Polym. Chem. Ed., Vol. 24, 2971-2980 (1986) bekannt. Verwendet man jedoch diejenigen Copolymeren dieser Gruppe, die noch alkalilöslich sind, in Verbindung mit den kommerziellen Sulfoniumsalzen, wie Triphenylsulfoniumhexafluoroarsenat, wie auch in US-A 4,491,628 beschrieben, so haben diese Gemische den Nachteil, daß ein sehr hoher Abtrag der unbelichteten Bereiche stattfindet, da die genannten Sulfoniumsalze nicht genügend zur Löslichkeitsinhibierung beitragen.

In der DE-A 37 21 741 werden strahlungsempfindliche Gemische beschrieben, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt.

Aus der DE-C 23 06 248 ist ein durch Belichten löslich werdendes Stoffgemisch und ein lichtempfindliches Aufzeichnungsmaterial bekannt, das einen photoaktiven Säurespender (halogenhaltiges s-Triazinderivat oder Diazoniumsalz) und ein Reaktionsprodukt einer mindestens eine Alkylvinylethergruppe enthaltenden organischen Verbindung mit einem einoder mehrwertigen Phenol enthält. Zusätzlich kann noch ein phenolisches Bindemittel enthalten sein. Als Alkylvinylether wird Dihydropyran explizit beansprucht. Diese Systeme weisen jedoch zu geringe thermische Stabilität auf und ergeben Struktureigenschaften, die sie für den Submikronbereich ungeeignet machen.

Poly[p-hydroxistyrol], dessen OH-Gruppen teilweise oder ganz mit Dihydropyran zu Tetrahydropyranyl-ethern umgesetzt wurde, ist ebenfalls als Bestandteil lichtempfindlicher Gemische aus JP 2248952, JP 03083063, JP 02025850, JP 02161436, EP 0 342 498, EP 0 388 813 und DE-A-4 007 924 bekannt. Nachteilig bei diesen Systemen ist die Gefahr der Vernetzung bei Überbelichtung oder zu hoher Temperaturen beim Ausheiz-Schritt nach der Belichtung (L. Schlegel, T. Ueno, H. Shiraishi, N. Hayashi und T. Iwayanagi, Microelectron. Eng. 13, 33 (1991)). Außerdem benötigen diese Systeme für die Entwicklung alkalische Entwickler mit n-Propanol-Zusatz, was in bezug auf die Entsorgung als ein Nachteil anzusehen ist (S.A.M. Hesp, N. Hayashi und T. Ueno, J. Appl. Polym. Sci. 42, 877 (1991)).

In der US-A 4 101 323 sind strahlungsempfindliche Kopiermassen beschrieben, die Bindemittel, die in der Hauptkette säurespaltbare -C-O-C-Gruppierungen enthalten, sowie eine Polychlorverbindung als Säurespender enthalten. In EP-A 302 359 sind strahlungsempfindliche Kopiermassen beschrieben, die ein Dreikomponentensystem aus alkalilöslichem phenolischem Bindemittel, einer Polychlorverbindung als Säurespender und einer Verbindung mit zwei Acetalgruppen als Inhibitor enthalten. Während die in oben genannter US-Patentschrift beschriebenen Kopiermassen ungenügende Reproduzierbarkeit bei ihrer Herstellung aufweisen, ergeben sich bei den in der EP-A beschriebenen Kopiermassen die bereits oben genannten Nachteile der Dreikomponentensysteme.

In der EP-B 447 868 der Anmelderin sind strahlungsempfindliche Mischungen aus einem phenolischen Harz beschrieben, dessen phenolische Hydroxylgruppen zum Teil durch Acetalgruppen, insbesondere durch 2-Tetrahydropyranyl- oder 2-Tetrahydrofuranylgruppen geschützt sind. Die EP-A 520 642 beschreibt Photoresistmischungen, die

als Photoinitiatoren vor allem Diazomethanverbindungen und als Bindemittel meist mit Acetalgruppen geschützte phenolische Polymere enthalten. Beide Systeme haben den Nachteil, daß sie bei Überbelichtung oder höheren Ausheiztemperaturen zu Vernetzungen neigen und bzgl. der erzielten Auflösung Wünsche offen lassen.

Aufgabe der vorliegenden Erfindung ist es, neue positiv arbeitende hochaktive strahlungsempfindliche Systeme für die Herstellung von Reliefstrukturen aufzuzeigen, die sich mit wäßrig-alkalischen Lösungen entwickeln lassen und die Herstellung von im kurzwelligen UV lichtempfindlichen Schichten ermöglichen.

Dazu soll ein strahlungsempfindliches Gemisch, das im wesentlichen ein in Wasser unlösliches Bindemittel mit einer säurelabilen Gruppierung, die durch Einwirkung von Säure gespalten wird, und eine bei Bestrahlung eine starke Säure bildende Verbindung enthält, bildmäßig bestrahlt, erwärmt und die bildmäßig bestrahlten Schichtbereiche mit Entwicklerlösung ausgewaschen werden.

Überraschenderweise wurde gefunden, daß durch den Ersatz von 5 bis 100 % der phenolischen Hydroxylgruppen eines polymeren Bindemittels wie Novolak oder Poly-(hydroxystyrol), durch Ketalgruppierungen hochaktive strahlungsempfindliche Systeme erhalten werden, die die oben beschriebenen Nachteile der Acetal-Gruppierungen - insbesondere die Neigung zur Vernetzung - nicht aufweisen und sich durch sehr gute Reproduzierbarkeit und hohe Auflösung auszeichnen.

Gegenstand der vorliegenden Erfindung ist ein strahlungsempfindliches Gemisch, im wesentlichen bestehend aus

(a) einem in Wasser unlöslichen Bindemittel oder Bindemittelgemisch und

(b) einer bei Bestrahlung eine starke Säure bildenden Verbindung,

das dadurch gekennzeichnet ist, daß Komponente (a) ein phenolisches Harz ist, dessen phenolische Hydroxylgruppen zu 5 bis 100 % durch Gruppierungen der allgemeinen Formel (IA)

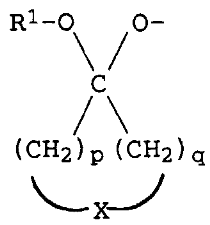

(IA),

worin $R^1$ geradkettige oder verzweigte Alkylreste mit 1 bis 16 Kohlenstoffatomen, Cycloalkylreste mit 5 bis 16 Kohlenstoffatomen, Oxaalkyl-, Thiaalkyl-, Azaalkylreste mit bis zu 8 Sauerstoff-, Schwefel- oder Stickstoffatomen und bis zu 16 Kohlenstoffatomen und X = $CH_2$, O, S, $SO_2$, $NR^2$ mit $R^2$ = Alkyl, Aryl, substituiertes Aryl, Aralkyl mit bis zu 16 Kohlenstoffatomen, bedeuten
oder durch Gruppierungen der allgemeinen Formel (IB)

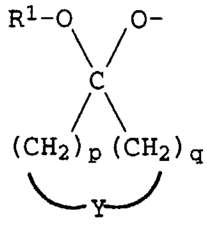

(IB),

worin $R^1$ und $R^2$ die oben genannte Bedeutung haben und p = 1 bis 6, q = 1 bis 6, Y = O, S, $SO_2$ oder $NR^2$ bedeuten, wobei bei Komponenten (a) mit Gruppierungen (IA), in denen X = $CH_2$ ist, als Komponenten (b) Sulfoniumsalze der Formel IV verwendet werden.

Bevorzugt sind solche erfindungsgemäße strahlungsempfindlichen Gemische, in welchen als Komponente (a) Poly-(p-hydroxistyrol) oder Poly-(p-hydroxi-α-methylstyrol) mit mittleren Molekulargewichten $\overline{M}_n$ zwischen 200 und 200 000 eingesetzt wird, wobei 5 bis 95, insbesondere 10 bis 80 % der phenolischen Hydroxylgruppen durch Gruppierungen der allgemeinen Formeln (IA) und/oder (IB) ersetzt sind, sowie solche strahlungsempfindlichen Gemische,

in denen Komponente (a) Gruppierungen (II) und (III) enthält,

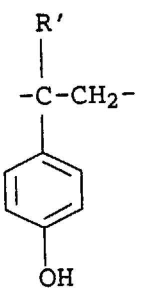

(II)

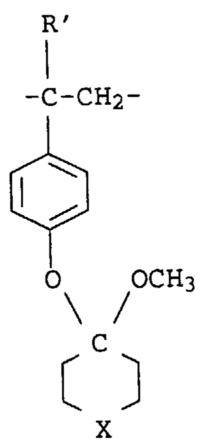

(III)

worin R' für H oder $CH_3$ steht und X für O, S oder $SO_2$ steht.

Bevorzugte Ausführungsformen bestehen darin, daß im erfindungsgemäßen strahlungsempfindlichen Gemisch das Bindemittel (a) nur Struktureinheiten (II) und (III) im Verhältnis 1:10 bis 10:1 enthält.

Besonders bevorzugt ist als Bindemittel (a) ein Umsetzungsprodukt von Poly-(p-hydroxistyrol) mit 4-Methoxy-5,6-dihydro-2*H*-pyran zu verwenden.

Die erfindungsgemäßen strahlungsempfindlichen Gemische enthalten als Komponente (b) vorzugsweise ein Sulfonium- oder Jodoniumsalz der allgemeinen Formel (IV) oder (V)

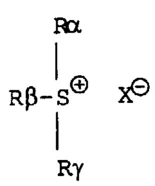

(IV)

bzw.

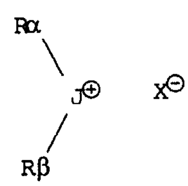

(V)

worin Rα, Rβ und Rγ untereinander gleich oder verschieden sind und für Alkyl mit 1 bis 3 Kohlenstoffatomen, Aryl, substituiertes Aryl oder Aralkyl stehen und $X^\ominus$ = $ClO_4^\ominus$, $AsF_6^\ominus$, $SbF_6^\ominus$, $PF_6^\ominus$, $BF_4^\ominus$ und/oder $CF_3SO_3^\ominus$ ist, insbesondere solche, in denen mindestens einer der Reste Rα, Rβ und Rγ für einen Rest der allgemeinen Formel (VI)

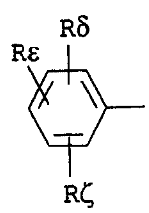

(VI)

steht, worin Rδ, Rε und Rζ untereinander gleich oder verschieden sind und für H, OH, Halogen, Alkyl oder Alkoxy mit jeweils 1 bis 4 Kohlenstoffatomen stehen. Im Falle, daß Komponente (a) Gruppierungen der Formel (IA) enthält, in denen X = $CH_2$ ist, ist als Komponente (b) ein Sulfoniumsalz der Formel (IV) zwingend, in denen mindestens einer der Reste Rα, Rβ oder Rγ ein Hydrophenylrest ist.

Als organische Verbindung (b) können, wenn X in Komponente (a) nicht $CH_2$ ist, auch Sulfoniumsalze der

allgemeinen Formel (VII) eingesetzt werden

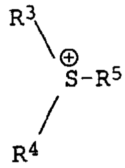 $X^{\ominus}$ (VII)

worin $R^3$, $R^4$ und $R^5$ untereinander gleich oder verschieden sind und für aliphatische und/oder aromatische Reste, die gegebenenfalls Heteroatome enthalten, stehen oder zwei der Reste $R^3$ bis $R^5$ miteinander zu einem Ring verknüpft sind, mit der Maßgabe, daß mindestens einer der Reste $R^3$ bis $R^5$ mindestens eine durch Säure spaltbare Gruppierung enthält, wobei einer der Reste $R^3$ bis $R^5$ mit einem oder mehreren weiteren Sulfoniumsalzresten, gegebenenfalls über durch Säure abspaltbare Gruppierungen, verknüpft sein kann, und $X^{\ominus}$ ein nichtnukleophiles Gegenion bedeutet.

Ebenso können die erfindungsgemäßen strahlungsempfindlichen Gemische, wenn X in Komponente (a) nicht $CH_2$ ist, als Komponente (b) einen Sulfonsäureester, einen Alkylsulfonsäureester einer Verbindung mit mindestens zwei phenolischen Hydroxylgruppen oder ein Disulfon enthalten.

Im erfindungsgemäßen strahlungsempfindlichen Gemisch kann die Komponente (a) in einer Menge von 80 bis 99 Gew.% und Komponente (b) in einer Menge von 1 bis 20 Gew.% enthalten sein.

Das erfindungsgemäße strahlungsempfindliche Gemisch kann zusätzlich einen Sensibilisator enthalten, der Strahlung absorbiert und auf Komponente (b) überträgt, sowie zusätzlich bis zu 1 Gew.% eines Haftvermittlers, Tensids oder Farbstoffe enthalten.

Gegenstand der vorliegenden Erfindung ist außerdem ein Verfahren zur Herstellung lichtempfindlicher Beschichtungsmaterialien, wobei das erfindungsgemäße strahlungsempfindliche Gemisch eingesetzt wird, sowie ein Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 130°C, bildmäßiges Belichten, gegebenenfalls Erhitzen auf Temperaturen von 40 bis 160°C, und Entwickeln mit einer wäßrig-alkalischen Lösung, wobei das erfindungsgemäße strahlungsempfindliche Gemisch eingesetzt wird.

Zu den Aufbaukomponenten des erfindungsgemäßen strahlungsempfindlichen Gemisches ist im einzelnen folgendes auszuführen.

a) Als in Wasser unlösliche Bindemittel oder Bindemittelgemische kommen wegen der meist erforderlichen Plasmaätzstabilität phenolische Harze in Betracht, deren phenolische Hydroxylgruppen zu 5 bis 100, insbesondere 10 bis 80 % durch die Gruppierungen (IA) und/oder (IB) ersetzt sind, wie z.B. entsprechende Novolake mit Molekulargewichten $\overline{M}_n$ zwischen 300 und 20.000, vorzugsweise zwischen 300 und 2000 g/mol, für Belichtung im kurzwelligen UV-Bereich (≤300 nm) insbesondere Novolake auf Basis p-Kresol/Formaldehyd, Poly(p-hydroxistyrole) und Poly(p-hydroxi-α-methylstyrole) oder Copolymere von p-Hydroxistyrol bzw. p-Hydroxi-α-methylstyrol, wobei diese Poly(p-hydroxistyrole) im allgemeinen Molekulargewichte $\overline{M}_n$ zwischen 200 und 200.000, vorzugsweise zwischen 1000 und 40.000 g/mol aufweisen. Diese Poly(p-hydroxistyrole) können auch in bekannter Weise durch (polymeranaloge) Umsetzung ihrer Hydroxylgruppen mit z.B. 4-Methoxy-5,6-dihydro-2*H*-pyran, erfindungsgemäß modifiziert sein. Die so erhältlichen und im vorliegenden Falle auch als Copolymerisate verstandenen modifizierten polymeren Bindemittel (a) sind vorzugsweise solche, die im wesentlichen aus Gruppierungen (II) zusammen mit (III) bestehen,

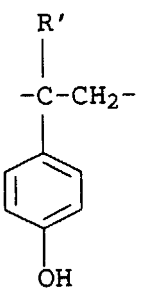

(II)

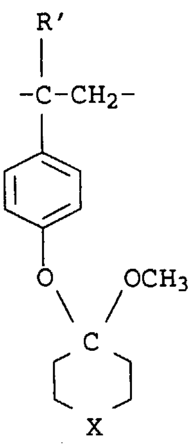

(III)

worin R' für H oder $CH_3$ steht und X für O, S oder $SO_2$ steht.

Die Herstellung der erfindungsgemäß einzusetzenden Polymeren kann durch säurekatalysierte, polymeranaloge Umsetzung der entsprechenden Novolake oder Poly-(hydroxistyrole) in Analogie zu der für niedermolekulare Substanzen üblichen und bekannten Weise (vgl. z.B. T.W. Greene, Protective Groups in Organic Synthesis, John Wiley & Sons, New York 1981) mit den entsprechenden olefinisch ungesättigten Verbindungen erfolgen.

Ein besonders bevorzugtes Ausgangsmaterial ist:

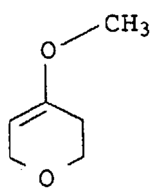

(A)

Dabei wird z.B. bei der teilweisen Umsetzung von Poly-(hydroxistyrol) mit (A) eine Gruppierung der allgemeinen Formel (III) erhalten.

Die Bestimmung des Umsetzungsgrads kann NMR-spektroskopisch erfolgen.

Es eignen sich auch Gemische der obengenannten Bindemittel (a). Bindemittel (a) ist im erfindungsgemäßen Gemisch im allgemeinen in Mengen von 80 bis 99, vorzugsweise 90 bis 97 Gew.-%, bezogen auf die Gesamtmenge des strahlungsempfindlichen Gemisches (a) + (b) enthalten.

Als bei Bestrahlung eine starke Säure bildende Verbindungen (b) kommen für Komponenten (a), in denen X nicht $CH_2$ ist, im Prinzip alle Verbindungen in Frage, die diese Eigenschaft aufweisen und so als Säurespender wirksam sind. Für die Bestrahlung mit kurzwelligen UV-Strahlen sind jedoch Iodonium- und insbesondere Sulfoniumsalze bevorzugt. Diese entsprechen den allgemeinen Formeln (IV) bzw. (V)

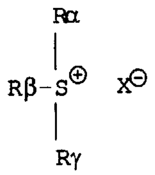 bzw. 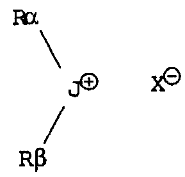

(IV) (V)

worin Rα, Rβ und Rγ untereinander gleich oder verschieden sind und für Alkyl, beispielsweise mit 1 bis 5 Kohlenstoffatomen, vorzugsweise Methyl oder Ethyl, Aryl, wie z.B. Phenyl oder Aralkyl, wie z.B. Benzyl, oder den Rest

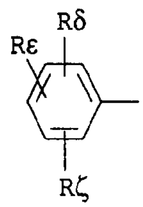

stehen, worin Rδ, Rε und Rζ untereinander gleich oder verschieden sind und für Wasserstoff, OH, Halogen, wie z.B. Chlor oder Brom, Alkyl, beispielsweise mit 1 bis 4 Kohlenstoffatomen, vorzugsweise Methyl oder tert.Butyl oder Alkoxi, beispielsweise mit 1 bis 4 Kohlenstoffatomen, vorzugsweise Methoxi oder tert.Butoxi, stehen und $X^{\ominus}$ = $AsF_6^{\ominus}$, $SbF_6^{\ominus}$ , $PF_6^{\ominus}$, $BF_4^{\ominus}$, $ClO_4^{\ominus}$ oder $CF_3SO_3^{\ominus}$ ist.

Beispiele für besonders gut geeignete Komponenten (b) sind Triphenylsulfoniumsalze und Diphenyliodoniumsalze, Tris(4-hydroxiphenyl)-sulfoniumsalz, Tris(4-ethyloxicarbonyl-oxiphenyl)sulfoniumsalz, jeweils mit $X^{\ominus}$ - = $ClO_4^{\ominus}$ -, $AsF_6^{\ominus}$, $PF_6^{\ominus}$, $SbF_6^{\ominus}$, $BF_4^{\ominus}$ und/oder $CF_3SO_3^{\ominus}$ als Gegenionen.

Ebenfalls besonders bevorzugt als Komponente (b) sind Alkylsulfonsäureester von Verbindungen, die mindestens zwei phenolische OH-Gruppen enthalten. Beispiele besonders gut geeigneter Substanzen sind 1,2,3-Tris-(methansulfonyloxy)benzol und 1,3-Bis-(methansulfonyloxy)benzol.

Auch Gemische der unter (b) genannten Verbindungen können eingesetzt werden. Komponente (b) ist im erfindungsgemäßen strahlungsempfindlichen Gemisch im allgemeinen in Mengen von 1 bis 20, vorzugsweise 2 bis 10 Gew.%, bezogen auf die Gesamtmenge des strahlungsempfindlichen Gemisches (a) + (b), enthalten.

Das erfindungsgemäße strahlungsempfindliche Gemisch kann zusätzlich noch weitere übliche Hilfs- und Zusatzstoffe enthalten.

Die erfindungsgemäßen Gemische werden bevorzugt in einem organischen Lösungsmittel gelöst, wobei der Feststoffgehalt im allgemeinen im Bereich zwischen 5 und 40 Gew.% liegt. Als Lösungsmittel kommen bevorzugt aliphatische Ketone, Ether und Ester, sowie Mischungen derselben in Frage. Besonders bevorzugt sind Alkylenglykol-monoalkylether, wie beispielsweise Ethyl-cellosolve, Butylglykol, Methyl-cellosolve und l-Methoxy-2-propanol, Alkylenglykol-alkylether-ester, wie beispielsweise Methyl-cellosolveacetat, Ethyl-cellosolveacetat, Methyl-propylenglykol-acetat und Ethylpropylenglykol-acetat, Ketone, wie beispielsweise Cyclohexanon, Cyclopentanon und Methyl-ethyl-keton, sowie Acetate wie Butylacetat und Aromaten, wie Toluol und Xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler, Netzmittel, Farbstoffe und Weichmacher zugesetzt werden, im allgemeinen in Mengen von bis zu 1 Gew.-%.

Die erfindungsgemäßen strahlungsempfindlichen Gemische sind sensitiv gegenüber Röntgen-, Elektronen- und UV-Strahlung. Gegebenenfalls können Sensibilisatoren in geringen Mengen zugesetzt werden, wie beispielsweise Pyren und Perylen, um die Verbindungen im längerwelligen UV bis hin zum sichtbaren Wellenlängenbereich zu sensibilisieren. Für die Belichtung in speziellen Wellenlängenbereichen, wie beispielsweise im kurzwelligen UV (< 300 nm), ist eine hohe Transparenz der Schichten bei der jeweiligen Belichtungswellenlänge gefordert. In gängigen Belichtungsgeräten auf Basis von Quecksilberlampen nutzt man die 254 nm Linie oder man verwendet Excimer-Laser, die bei 248 nm (KrF) emittieren. Strahlungsempfindliche Aufzeichnungsmaterialien sollten deshalb in diesem Bereich möglichst niedrige optische Dichten aufweisen. Für diese Anwendungen haben sich die erfindungsgemäßen polymeren Bindemittel auf Basis von Novolaken als weniger geeignet herausgestellt, so daß für diese speziellen Anwendungen

bevorzugt die polymeren Bindemittel auf Basis von Hydroxistyrolen eingesetzt werden.

Bei dem erfindungsgemäßen Verfahren zur Herstellung von positiven Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche nach einem thermischen Ausheizschritt bei Temperaturen zwischen 40 und 160°C in wäßrig-alkalischen Lösungsmitteln zunimmt und diese Bereiche selektiv mit dem alkalischen Entwickler entfernt werden können.

Die das erfindungsgemäße strahlungsempfindliche Gemisch enthaltenden Photoresistlösungen werden im allgemeinen in Schichtdicken von 0,1 bis 5 µm, vorzugsweise 0,5 bis 1,5 µm auf geeignete Substrate, beispielsweise oberflächlich oxidierte Silizium-Wafer durch Aufschleudern (spin coating) aufgetragen, getrocknet (z.B. bei Temperaturen zwischen 70 und 130°C) und mit einer geeigneten Lichtquelle durch eine Photomaske bildmäßig belichtet, z.B. mit kurzwelligen UV-Strahlen (deep UV) mit Wellenlängen zwischen 200 und 300 nm. Besonders geeignete Lichtquellen sind Excimer-Laser von KrF (248 nm). Nach dem bildmäßigen Belichten wird - gegebenenfalls nach kurzem Ausheizen (postbake) bei Temperaturen bis zu 160°C - mit üblichen wäßrig-alkalischen Entwicklerlösungen - im allgemeinen bei pH-Werten zwischen 12 und 14 - entwickelt, wobei die belichteten Stellen ausgewaschen werden. Die Auflösung liegt im Submikron-Bereich. Die für die erfindungsgemäßen strahlungsempfindlichen Gemische benötigte Belichtungsenergie liegt im allgemeinen zwischen 10 und 300 $mJ/cm^2$ bei Schichtdicken von 1 µm.

Die erfindungsgemäßen strahlungsempfindlichen Gemische zeichnen sich durch hohe Empfindlichkeit, gute Auflösung und leichte Verarbeitbarkeit aus und eignen sich daher besonders vorteilhaft für die Lithographie im kurzwelligen Bereich.

Gegenüber den bekannten, acetal-haltigen Systemen, insbesondere denjenigen mit Tetrahydropyranylethern haben diese Systeme den Vorteil eines weiten Arbeitsbereichs, ohne dabei die Gefahr der Vernetzung aufzuweisen, unabhängig von der Art des Säurespenders und/oder der Temperatur des Ausheizschritts. Ebenfalls ein großer Vorteil ist, daß als Entwickler wäßrige alkalische Lösungen, ohne den Zusatz eines organischen Lösungsmittels verwendet werden können.

Die in den Beispielen angegebenen Teile und Prozente sind, soweit nicht anders angegeben, Gewichtsteile bzw. Gewichtsprozente.

Beispiel 1

Eine Resistlösung wird aus 95 Teilen eines Poly-(p-hydroxistyrols), dessen phenolische OH-Gruppen zu 32 % als 4-Methoxytetrahydropyran-Ether geschützt sind, 5 Teilen Triphenylsulfoniumtriflat und 300 Teilen Propylenglykolmonomethylether-acetat hergestellt. Die Lösung wird anschließend durch ein Filter mit einem Porendurchmesser von 0,2 µm filtriert.

Die Resistlösung wird auf einen Silizium-Wafer, der mit Hexamethyldisilazan als Haftvermittler überzogen ist, aufgeschleudert, wobei eine Schichtdicke von etwa 1 µm erhalten wird. Der Wafer wird anschließend 1 min bei 90°C auf einer Heizplatte getrocknet und dann mit einem Excimer-Laser bei 248 nm belichtet. Danach wird der Wafer 1 min bei 90°C ausgeheizt und in einer wäßrigen Lösung von Tetra-N-methylammonium-hydroxid von pH 12 - 13,6 entwickelt.

Die Lichtempfindlichkeit beträgt 11 $mJ/cm^2$.

Beispiel 2

Wie in Beispiel 1 beschrieben, wird eine Photoresistlösung hergestellt. Diesmal wird jedoch 4-Hydroxiphenyldimethylsulfoniumtriflat als Säurespender und als Lösungsmittel Ethyllactat verwendet. Der Ausheizschritt nach der Belichtung wird hier bei 120°C durchgeführt.

Die Lichtempfindlichkeit beträgt 9 $mJ/cm^2$, es lassen sich auch in den stark belichteten Bereichen keine Anzeichen von Vernetzung erkennen.

Beispiel 3

Wie in Beispiel 1 beschrieben, wird eine Photoresistlösung hergestellt. Diesmal wird jedoch 1,2,3-Tris-(methansulfonyloxi)-benzol als Säurespender verwendet.

Die Lichtempfindlichkeit beträgt 49 $mJ/cm^2$.

Beispiel 4

Wie in Beispiel 1 beschrieben, wird eine Photoresistlösung hergestellt. Diesmal wird jedoch Phenyl-(4-anisyl) -disulfon als Säurespender verwendet.

Die Lichtempfindlichkeit beträgt 10 $mJ/cm^2$.

Vergleichsbeispiel 1

Eine Resistlösung wird aus 95 Teilen eines Poly-(p-hydroxistyrols), dessen phenolische OH-Gruppen zu 36 % als Tetrahydropyran-Ether geschützt sind, 5 Teilen 4-Hydroxiphenyldimethyl-sulfonium triflat und 250 Teilen Ethyllactat hergestellt.

Nach Verarbeitung wie in Beispiel 2 findet man in den stark belichteten Bereichen (> 200 mJ/cm$^2$) unlösliches Material, was auf Vernetzung zurückzuführen ist.

**Beschreibung für folgende Vertragsstaaten : BE, IT, NL**

Die Erfindung betrifft positiv arbeitende strahlungsempfindliche Gemische, die ein in Wasser unlösliches Bindemittel und eine unter Einwirkung von Strahlung eine Säure bildende Verbindung, enthalten, wobei das Bindemittel bestimmte Gruppierungen enthält, die durch säurekatalytische Einwirkung verseift werden, wodurch die Alkalilöslichkeit des Gemisches erhöht wird. Diese Gemische sind sensitiv gegenüber UV-, Elektronen- und Röntgenstrahlen und eignen sich besonders als Resistmaterial.

Positiv arbeitende strahlungsempfindliche Gemische sind bekannt und besonders positiv arbeitende Resistmaterialien, die o-Chinondiazide in wäßrig-alkalisch löslichen Bindemitteln, z.B. Novolaken oder Poly(p-hydroxi-styrol) en, enthalten, werden kommerziell eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärphotoreaktion eine Spezies erzeugen, die dann unabhängig von der Strahlung eine katalytische Sekundärreaktion auslöst, sind beschrieben. So sind in der US-A 3,915,706 beispielsweise Photoinitiatoren beschrieben, die eine starke Säure erzeugen, die dann in einer Sekundärreaktion säurelabile Gruppen, wie Polyaldehydgruppierungen spalten.

Weiterhin sind strahlungsempfindliche Gemische auf Basis von säurespaltbaren Verbindungen bekannt, die als Bindemittel ein wäßrig-alkalisch lösliches Polymer sowie eine Verbindung, die photochemisch eine starke Säure bildet, und eine weitere Verbindung mit durch Säure spaltbaren Bindungen, die durch die Einwirkung der Säure ihre Löslichkeit in einem alkalischen Entwickler erhöhen, enthalten (vgl. DE-A 3 406 927). Als photochemisch eine starke Säure bildende Verbindungen werden Diazonium-, Phosphonium-, Sulfonium- und Iodonium-, sowie Halogenverbindungen genannt. Die Verwendung dieser Oniumsalze als photochemische Säurespender in Resistmaterialien ist z.B. auch aus US-A 4,491,628 bekannt. Einen Überblick über die Anwendung von Oniumsalzen in Resistmaterialien gibt Crivello in Org. Coatings and Appl. Polym. Sci., 48, p. 65-69 (1985).

Copolymere mit phenolischen und säurelabilen Gruppen, wie beispielsweise Poly-(p-hydroxistyrol-co-t-butoxicarbonyloxistyrol), sind aus J. Polym. Sci., Part A, Polym. Chem. Ed., Vol. 24, 2971-2980 (1986) bekannt. Verwendet man jedoch diejenigen Copolymeren dieser Gruppe, die noch alkalilöslich sind, in Verbindung mit den kommerziellen Sulfoniumsalzen, wie Triphenylsulfoniumhexafluoroarsenat, wie auch in US-A 4,491,628 beschrieben, so haben diese Gemische den Nachteil, daß ein sehr hoher Abtrag der unbelichteten Bereiche stattfindet, da die genannten Sulfoniumsalze nicht genügend zur Löslichkeitsinhibierung beitragen.

In der DE-A 37 21 741 werden strahlungsempfindliche Gemische beschrieben, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt.

Aus der DE-C 23 06 248 ist ein durch Belichten löslich werdendes Stoffgemisch und ein lichtempfindliches Aufzeichnungsmaterial bekannt, das einen photoaktiven Säurespender (halogenhaltiges s-Triazinderivat oder Diazoniumsalz) und ein Reaktionsprodukt einer mindestens eine Alkylvinylethergruppe enthaltenden organischen Verbindung mit einem ein- oder mehrwertigen Phenol enthält. Zusätzlich kann noch ein phenolisches Bindemittel enthalten sein. Als Alkylvinylether wird Dihydropyran explizit beansprucht. Diese Systeme weisen jedoch zu geringe thermische Stabilität auf und ergeben Struktureigenschaften, die sie für den Submikronbereich ungeeignet machen.

Poly[p-hydroxistyrol], dessen OH-Gruppen teilweise oder ganz mit Dihydropyran zu Tetrahydropyranyl-ethern umgesetzt wurde, ist ebenfalls als Bestandteil lichtempfindlicher Gemische aus JP 2248952, JP 03083063, JP 02025850, JP 02161436, EP 0 342 498, EP 0 388 813 und DE-A-4 007 924 bekannt. Nachteilig bei diesen Systemen ist die Gefahr der Vernetzung bei Überbelichtung oder zu hoher Temperaturen beim Ausheiz-Schritt nach der Belichtung (L. Schlegel, T. Ueno, H. Shiraishi, N. Hayashi und T. Iwayanagi, Microelectron. Eng. 13, 33 (1991)). Außerdem benötigen diese Systeme für die Entwicklung alkalische Entwickler mit n-Propanol-Zusatz, was in bezug auf die Entsorgung als ein Nachteil anzusehen ist (S.A.M. Hesp, N. Hayashi und T. Ueno, J. Appl. Polym. Sci. 42, 877 (1991)).

In der US-A 4 101 323 sind strahlungsempfindliche Kopiermassen beschrieben, die Bindemittel, die in der Hauptkette säurespaltbare -C-O-C-Gruppierungen enthalten, sowie eine Polychlorverbindung als Säurespender enthalten. In EP-A 302 359 sind strahlungsempfindliche Kopiermassen beschrieben, die ein Dreikomponentensystem aus alkalilöslichem phenolischem Bindemittel, einer Polychlorverbindung als Säurespender und einer Verbindung mit zwei

Acetalgruppen als Inhibitor enthalten. Während die in oben genannter US-Patentschrift beschriebenen Kopiermassen ungenügende Reproduzierbarkeit bei ihrer Herstellung aufweisen, ergeben sich bei den in der EP-A beschriebenen Kopiermassen die bereits oben genannten Nachteile der Dreikomponentensysteme.

In der EP-B 447 868 der Anmelderin sind strahlungsempfindliche Mischungen aus einem phenolischen Harz beschrieben, dessen phenolische Hydroxylgruppen zum Teil durch Acetalgruppen, insbesondere durch 2-Tetrahydropyranyl- oder 2-Tetrahydrofuranylgruppen geschützt sind. Die EP-A 520 642 beschreibt Photoresistmischungen, die als Photoinitiatoren vor allem Diazomethanverbindungen und als Bindemittel meist mit Acetalgruppen geschützte phenolische Polymere enthalten. Beide Systeme haben den Nachteil, daß sie bei Überbelichtung oder höheren Ausheiztemperaturen zu Vernetzungen neigen und bzgl. der erzielten Auflösung Wünsche offen lassen.

Aufgabe der vorliegenden Erfindung ist es, neue positiv arbeitende hochaktive strahlungsempfindliche Systeme für die Herstellung von Reliefstrukturen aufzuzeigen, die sich mit wäßrig-alkalischen Lösungen entwickeln lassen und die Herstellung von im kurzwelligen UV lichtempfindlichen Schichten ermöglichen.

Dazu soll ein strahlungsempfindliches Gemisch, das im wesentlichen ein in Wasser unlösliches Bindemittel mit einer säurelabilen Gruppierung, die durch Einwirkung von Säure gespalten wird, und eine bei Bestrahlung eine starke Säure bildende Verbindung enthält, bildmäßig bestrahlt, erwärmt und die bildmäßig bestrahlten Schichtbereiche mit Entwicklerlösung ausgewaschen werden.

Überraschenderweise wurde gefunden, daß durch den Ersatz von 5 bis 100 % der phenolischen Hydroxylgruppen eines polymeren Bindemittels wie Novolak oder Poly-(hydroxystyrol), durch Ketalgruppierungen hochaktive strahlungsempfindliche Systeme erhalten werden, die die oben beschriebenen Nachteile der Acetal-Gruppierungen - insbesondere die Neigung zur Vernetzung - nicht aufweisen und sich durch sehr gute Reproduzierbarkeit und hohe Auflösung auszeichnen.

Gegenstand der vorliegenden Erfindung ist ein strahlungsempfindliches Gemisch, im wesentlichen bestehend aus

(a) einem in Wasser unlöslichen Bindemittel oder Bindemittelgemisch und

(b) einer bei Bestrahlung eine starke Säure bildenden Verbindung,

das dadurch gekennzeichnet ist, daß Komponente (a) ein phenolisches Harz ist, dessen phenolische Hydroxylgruppen zu 5 bis 100 % durch Gruppierungen der allgemeinen Formel (I)

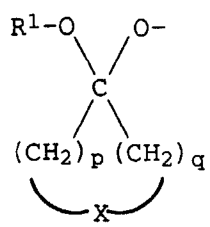

(I),

worin $R^1$ für geradkettige oder verzweigte Alkylreste mit 1 bis 16 C-Atomen (Kohlenstoffatomen), Cycloalkylreste mit 5 bis 16 C-Atomen, Oxaalkyl-, Thiaalkyl-, Azaalkylreste mit bis zu 8 Sauerstoff-, Schwefel- oder Stickstoffatomen und bis zu 16 C-Atomen stehen, p = 1 bis 6, q = 1 bis 6, X = $(CH_2)$, O, S, $SO_2$ oder $NR^2$ mit $R^2$ = Alkyl, Aryl, substituiertes Aryl, Aralkyl mit bis zu 16 Kohlenstoffatomen bedeuten.

Bevorzugt sind solche erfindungsgemäße strahlungsempfindlichen Gemische, in welchen als Komponente (a) Poly-(p-hydroxistyrol) oder Poly-(p-hydroxi-α-methylstyrol) mit mittleren Molekulargewichten $\overline{M}_n$ zwischen 200 und 200 000 eingesetzt wird, wobei 5 bis 95, insbesondere 10 bis 80 % der phenolischen Hydroxylgruppen durch Gruppierungen der allgemeinen Formel (I) ersetzt sind, sowie solche strahlungsempfindlichen Gemische, in denen Komponente (a) Gruppierungen (II) und (III) enthält,

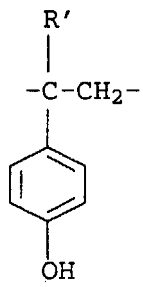

(II)

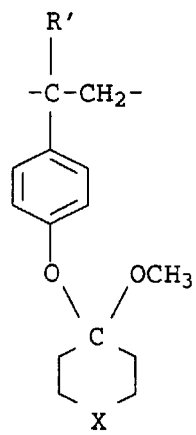

(III)

worin R' für H oder $CH_3$ steht und X für O, S oder $SO_2$ steht.

Bevorzugte Ausführungsformen bestehen darin, daß im erfindungsgemäßen strahlungsempfindlichen Gemisch das Bindemittel (a) nur Struktureinheiten (II) und (III) im Verhältnis 1:10 bis 10:1 enthält.

Besonders bevorzugt ist als Bindemittel (a) ein Umsetzungsprodukt von Poly-(p-hydroxistyrol) mit 4-Methoxy-5,6-dihydro-2*H*-pyran zu verwenden.

Die erfindungsgemäßen strahlungsempfindlichen Gemische enthalten als Komponente (b) vorzugsweise ein Sulfonium- oder Jodoniumsalz der allgemeinen Formel (IV) oder (V)

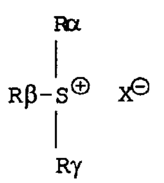

bzw.

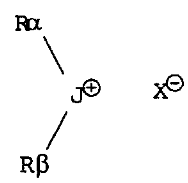

(IV) (V)

worin Rα, Rβ und Rγ untereinander gleich oder verschieden sind und für Alkyl mit 1 bis 3 Kohlenstoffatomen, Aryl, substituiertes Aryl oder Aralkyl stehen und $X^{\ominus} = ClO_4^{\ominus}$, $AsF_6^{\ominus}$, $SbF_6^{\ominus}$, $PF_6^{\ominus}$, $BF_4^{\ominus}$ und/oder $CF_3SO_3^{\ominus}$ ist, insbesondere solche, in denen mindestens einer der Reste Rα, Rβ und Rγ für einen Rest der allgemeinen Formel (VI)

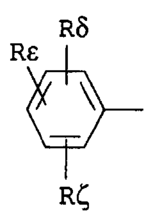

(VI)

steht, worin Rδ, Rε und Rζ untereinander gleich oder verschieden sind und für H, OH, Halogen, Alkyl oder Alkoxi mit jeweils 1 bis 4 Kohlenstoffatomen stehen.

Als organische Verbindung (b) können auch Sulfoniumsalze der allgemeinen Formel (VII) eingesetzt werden

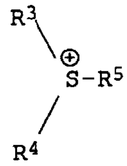 $X^{\ominus}$ (VII)

worin $R^3$, $R^4$ und $R^5$ untereinander gleich oder verschieden sind und für aliphatische und/oder aromatische Reste, die gegebenenfalls Heteroatome enthalten, stehen oder zwei der Reste $R^3$ bis $R^5$ miteinander zu einem Ring verknüpft sind, mit der Maßgabe, daß mindestens einer der Reste $R^3$ bis $R^5$ mindestens eine durch Säure spaltbare Gruppierung enthält, wobei einer der Reste $R^3$ bis $R^5$ mit einem oder mehreren weiteren Sulfoniumsalzresten, gegebenenfalls über durch Säure abspaltbare Gruppierungen, verknüpft sein kann, und $X^{\ominus}$ ein nichtnukleophiles Gegenion bedeutet.

Ebenso können die erfindungsgemäßen strahlungsempfindlichen Gemische als Komponente (b) einen Sulfonsäureester, einen Alkylsulfonsäureester einer Verbindung mit mindestens zwei phenolischen Hydroxylgruppen oder ein Disulfon enthalten.

Im erfindungsgemäßen strahlungsempfindlichen Gemisch kann die Komponente (a) in einer Menge von 80 bis 99 Gew.% und Komponente (b) in einer Menge von 1 bis 20 Gew.% enthalten sein.

Das erfindungsgemäße strahlungsempfindliche Gemisch kann zusätzlich einen Sensibilisator enthalten, der Strahlung absorbiert und auf Komponente (b) überträgt, sowie zusätzlich bis zu 1 Gew.% eines Haftvermittlers, Tensids oder Farbstoffe enthalten.

Gegenstand der vorliegenden Erfindung ist außerdem ein Verfahren zur Herstellung lichtempfindlicher Beschichtungsmaterialien, wobei das erfindungsgemäße strahlungsempfindliche Gemisch eingesetzt wird, sowie ein Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 1300C, bildmäßiges Belichten, gegebenenfalls Erhitzen auf Temperaturen von 40 bis 160°C, und Entwickeln mit einer wäßrig-alkalischen Lösung, wobei das erfindungsgemäße strahlungsempfindliche Gemisch eingesetzt wird.

Zu den Aufbaukomponenten des erfindungsgemäßen strahlungsempfindlichen Gemisches ist im einzelnen folgendes auszuführen.

a) Als in Wasser unlösliche Bindemittel oder Bindemittelgemische kommen wegen der meist erforderlichen Plasmaätzstabilität phenolische Harze in Betracht, deren phenolische Hydroxylgruppen zu 5 bis 100, insbesondere 10 bis 80 % durch die Gruppierung (I) ersetzt sind, wie z.B. entsprechende Novolake mit Molekulargewichten $\overline{M}_n$ zwischen 300 und 20.000, vorzugsweise zwischen 300 und 2000 g/mol, für Belichtung im kurzwelligen UV-Bereich (≤300 nm) insbesondere Novolake auf Basis p-Kresol/Formaldehyd, Poly(p-hydroxistyrole) und Poly(p-hydroxi-α-methylstyrole) oder Copolymere von p-Hydroxistyrol bzw. p-Hydroxi-α-methylstyrol, wobei diese Poly(p-hydroxistyrole) im allgemeinen Molekulargewichte $\overline{M}_n$ zwischen 200 und 200.000, vorzugsweise zwischen 1000 und 40.000 g/mol aufweisen. Diese Poly(p-hydroxistyrole) können auch in bekannter Weise durch (polymeranaloge) Umsetzung ihrer Hydroxylgruppen mit z.B. 4-Methoxy-5,6-dihydro-2H-pyran, erfindungsgemäß modifiziert sein. Die so erhältlichen und im vorliegenden Falle auch als Copolymerisate verstandenen modifizierten polymeren Bindemittel (a) sind vorzugsweise solche, die im wesentlichen aus Gruppierungen (II) zusammen mit (III) bestehen,

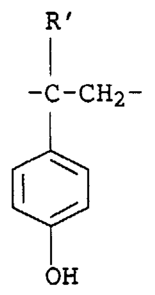

(II)

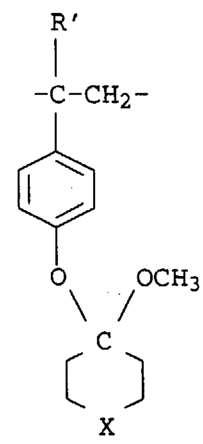

(III)

worin R' für H oder $CH_3$ steht und X für O, S oder $SO_2$ steht.

Die Herstellung der erfindungsgemäß einzusetzenden Polymeren kann durch säurekatalysierte, polymeranaloge Umsetzung der entsprechenden Novolake oder Poly-(hydroxistyrole) in Analogie zu der für niedermolekulare Substanzen üblichen und bekannten Weise (vgl. z.B. T.W. Greene, Protective Groups in Organic Synthesis, John Wiley & Sons, New York 1981) mit den entsprechenden olefinisch ungesättigten Vinylverbindungen erfolgen.

Ein besonders bevorzugtes Ausgangsmaterial ist:

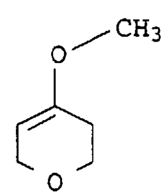

(A)

Dabei wird z.B. bei der teilweisen Umsetzung von Poly-(hydroxistyrol) mit (A) eine Gruppierung der allgemeinen Formel (III) erhalten.

Die Bestimmung des Umsetzungsgrads kann NMR-spektroskopisch erfolgen.

Es eignen sich auch Gemische der obengenannten Bindemittel (a). Bindemittel (a) ist im erfindungsgemäßen Gemisch im allgemeinen in Mengen von 80 bis 99, vorzugsweise 90 bis 97 Gew.-%, bezogen auf die Gesamtmenge des strahlungsempfindlichen Gemisches (a) + (b) enthalten.

Als bei Bestrahlung eine starke Säure bildende Verbindungen (b) kommen im Prinzip alle Verbindungen in Frage, die diese Eigenschaft aufweisen und so als Säurespender wirksam sind. Für die Bestrahlung mit kurzwelligen UV-Strahlen sind jedoch Iodonium- und insbesondere Sulfoniumsalze bevorzugt. Diese entsprechen den allgemeinen Formeln (IV) bzw. (V)

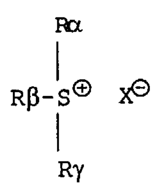

bzw.

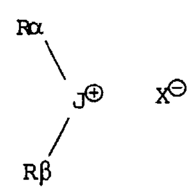

(IV) (V)

worin Rα, Rβ und Rγ untereinander gleich oder verschieden sind und für Alkyl, beispielsweise mit 1 bis 5 Kohlenstoffatomen, vorzugsweise Methyl oder Ethyl, Aryl, wie z.B. Phenyl oder Aralkyl, wie z.B. Benzyl, oder den Rest

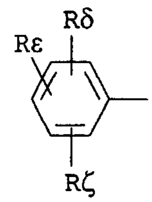

stehen, worin Rδ, Rε und Rζ untereinander gleich oder verschieden sind und für Wasserstoff, OH, Halogen, wie z.B. Chlor oder Brom, Alkyl, beispielsweise mit 1 bis 4 Kohlenstoffatomen, vorzugsweise Methyl oder tert.Butyl oder Alkoxi, beispielsweise mit 1 bis 4 Kohlenstoffatomen, vorzugsweise Methoxi oder tert.Butoxi, stehen und $X^{\ominus}$ = $AsF_6^{\ominus}$, $SbF_6^{\ominus}$ , $PF_6^{\ominus}$ , $BF_4^{\ominus}$ , $ClO_4^{\ominus}$ oder $CF_3SO_3^{\ominus}$ ist.

Beispiele für besonders gut geeignete Komponenten (b) sind Triphenylsulfoniumsalze und Diphenyliodoniumsalze, Tris(4-hydroxiphenyl)-sulfoniumsalz, Tris(4-ethyloxicarbonyl-oxiphenyl)sulfoniumsalz, jeweils mit $X^{\ominus}$ - = $ClO_4^{\ominus}$ -, $AsF_6^{\ominus}$, $PF_6^{\ominus}$, $SbF_6^{\ominus}$ , $BF_4^{\ominus}$ und/oder $CF_3SO_3^{\ominus}$ als Gegenionen.

Ebenfalls besonders bevorzugt als Komponente (b) sind Alkylsulfonsäureester von Verbindungen, die mindestens zwei phenolische OH-Gruppen enthalten. Beispiele besonders gut geeigneter Substanzen sind 1,2,3-Tris-(methansulfonyloxy)benzol und 1,3-Bis-(methansulfonyloxy)benzol.

Auch Gemische der unter (b) genannten Verbindungen können eingesetzt werden. Komponente (b) ist im erfindungsgemäßen strahlungsempfindlichen Gemisch im allgemeinen in Mengen von 1 bis 20, vorzugsweise 2 bis 10 Gew.%, bezogen auf die Gesamtmenge des strahlungsempfindlichen Gemisches (a) + (b), enthalten.

Das erfindungsgemäße strahlungsempfindliche Gemisch kann zusätzlich noch weitere übliche Hilfs- und Zusatzstoffe enthalten.

Die erfindungsgemäßen Gemische werden bevorzugt in einem organischen Lösungsmittel gelöst, wobei der Feststoffgehalt im allgemeinen im Bereich zwischen 5 und 40 Gew.% liegt. Als Lösungsmittel kommen bevorzugt aliphatische Ketone, Ether und Ester, sowie Mischungen derselben in Frage. Besonders bevorzugt sind Alkylenglykol-monoalkylether, wie beispielsweise Ethyl-cellosolve, Butylglykol, Methyl-cellosolve und 1-Methoxy-2-propanol, Alkylenglykol-alkylether-ester, wie beispielsweise Methyl-cellosolveacetat, Ethyl-cellosolveacetat, Methyl-propylenglykol-acetat und Ethylpropylenglykol-acetat, Ketone, wie beispielsweise Cyclohexanon, Cyclopentanon und Methyl-ethyl-keton, sowie Acetate wie Butylacetat und Aromaten, wie Toluol und Xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler, Netzmittel, Farbstoffe und Weichmacher zugesetzt werden, im allgemeinen in Mengen von bis zu 1 Gew.-%.

Die erfindungsgemäßen strahlungsempfindlichen Gemische sind sensitiv gegenüber Röntgen-, Elektronen- und UV-Strahlung. Gegebenenfalls können Sensibilisatoren in geringen Mengen zugesetzt werden, wie beispielsweise Pyren und Perylen, um die Verbindungen im längerwelligen UV bis hin zum sichtbaren Wellenlängenbereich zu sensibilisieren. Für die Belichtung in speziellen Wellenlängenbereichen, wie beispielsweise im kurzwelligen UV (< 300 nm), ist eine hohe Transparenz der Schichten bei der jeweiligen Belichtungswellenlänge gefordert. In gängigen Belichtungsgeräten auf Basis von Quecksilberlampen nutzt man die 254 nm Linie oder man verwendet Excimer-Laser, die bei 248 nm (KrF) emittieren. Strahlungsempfindliche Aufzeichnungsmaterialien sollten deshalb in diesem Bereich möglichst niedrige optische Dichten aufweisen. Für diese Anwendungen haben sich die erfindungsgemäßen polymeren Bindemittel auf Basis von Novolaken als weniger geeignet herausgestellt, so daß für diese speziellen Anwendungen bevorzugt die polymeren Bindemittel auf Basis von Hydroxistyrolen eingesetzt werden.

Bei dem erfindungsgemäßen Verfahren zur Herstellung von positiven Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche nach einem thermischen Ausheizschritt bei Temperaturen zwischen 40 und 160°C in wäßrig-alkalischen Lösungsmitteln zunimmt und diese Bereiche selektiv mit dem alkalischen Entwickler entfernt werden können.

Die das erfindungsgemäße strahlungsempfindliche Gemisch enthaltenden Photoresistlösungen werden im allgemeinen in Schichtdicken von 0,1 bis 5 µm, vorzugsweise 0,5 bis 1,5 µm auf geeignete Substrate, beispielsweise oberflächlich oxidierte Silizium-Wafer durch Aufschleudern (spin coating) aufgetragen, getrocknet (z.B. bei Temperaturen zwischen 70 und 130°C) und mit einer geeigneten Lichtquelle durch eine Photomaske bildmäßig belichtet, z.B.

mit kurzwelligen UV-Strahlen (deep UV) mit Wellenlängen zwischen 200 und 300 nm. Besonders geeignete Lichtquellen sind Excimer-Laser von KrF (248 nm). Nach dem bildmäßigen Belichten wird - gegebenenfalls nach kurzem Ausheizen (postbake) bei Temperaturen bis zu 160°C - mit üblichen wäßrig-alkalischen Entwicklerlösungen - im allgemeinen bei pH-Werten zwischen 12 und 14 - entwickelt, wobei die belichteten Stellen ausgewaschen werden. Die Auflösung liegt im Submikron-Bereich. Die für die erfindungsgemäßen strahlungsempfindlichen Gemische benötigte Belichtungsenergie liegt im allgemeinen zwischen 10 und 300 mJ/$cm^2$ bei Schichtdicken von 1 µm.

Die erfindungsgemäßen strahlungsempfindlichen Gemische zeichnen sich durch hohe Empfindlichkeit, gute Auflösung und leichte Verarbeitbarkeit aus und eignen sich daher besonders vorteilhaft für die Lithographie im kurzwelligen Bereich.

Gegenüber den bekannten, acetal-haltigen Systemen, insbesondere denjenigen mit Tetrahydropyranylethern haben diese Systeme den Vorteil eines weiten Arbeitsbereichs, ohne dabei die Gefahr der Vernetzung aufzuweisen, unabhängig von der Art des Säurespenders und/oder der Temperatur des Ausheizschritts. Ebenfalls ein großer Vorteil ist, daß als Entwickler wäßrige alkalische Lösungen, ohne den Zusatz eines organischen Lösungsmittels verwendet werden können.

Die in den Beispielen angegebenen Teile und Prozente sind, soweit nicht anders angegeben, Gewichtsteile bzw. Gewichtsprozente.

Beispiel 1

Eine Resistlösung wird aus 95 Teilen eines Poly-(p-hydroxistyrols), dessen phenolische OH-Gruppen zu 32 % als 4-Methoxytetrahydropyran-Ether geschützt sind, 5 Teilen Triphenylsulfoniumtriflat und 300 Teilen Propylenglykolmonomethylether-acetat hergestellt. Die Lösung wird anschließend durch ein Filter mit einem Porendurchmesser von 0,2 µm filtriert.

Die Resistlösung wird auf einen Silizium-Wafer, der mit Hexamethyldisilazan als Haftvermittler überzogen ist, aufgeschleudert, wobei eine Schichtdicke von etwa 1 µm erhalten wird. Der Wafer wird anschließend 1 min bei 900C auf einer Heizplatte getrocknet und dann mit einem Excimer-Laser bei 248 nm belichtet. Danach wird der Wafer 1 min bei 90°C ausgeheizt und in einer wäßrigen Lösung von Tetra-N-methylammonium-hydroxid von pH 12 - 13,6 entwickelt.

Die Lichtempfindlichkeit beträgt 11 mJ/$cm^2$.

Beispiel 2

Wie in Beispiel 1 beschrieben, wird eine Photoresistlösung hergestellt. Diesmal wird jedoch 4-Hydroxiphenyldimethylsulfoniumtriflat als Säurespender und als Lösungsmittel Ethyllactat verwendet. Der Ausheizschritt nach der Belichtung wird hier bei 120°C durchgeführt.

Die Lichtempfindlichkeit beträgt 9 mJ/$cm^2$, es lassen sich auch in den stark belichteten Bereichen keine Anzeichen von Vernetzung erkennen.

Beispiel 3

Wie in Beispiel 1 beschrieben, wird eine Photoresistlösung hergestellt. Diesmal wird jedoch 1,2,3-Tris-(methansulfonyloxi)-benzol als Säurespender verwendet.

Die Lichtempfindlichkeit beträgt 49 mJ/$cm^2$.

Beispiel 4

Wie in Beispiel 1 beschrieben, wird eine Photoresistlösung hergestellt. Diesmal wird jedoch Phenyl-(4-anisyl)-disulfon als Säurespender verwendet.

Die Lichtempfindlichkeit beträgt 10 mJ/$cm^2$.

Vergleichsbeispiel 1

Eine Resistlösung wird aus 95 Teilen eines Poly-(p-hydroxistyrols), dessen phenolische OH-Gruppen zu 36 % als Tetrahydropyran-Ether geschützt sind, 5 Teilen 4-Hydroxiphenyldimethyl-sulfonium triflat und 250 Teilen Ethyllactat hergestellt.

Nach Verarbeitung wie in Beispiel 2 findet man in den stark belichteten Bereichen (> 200 mJ/$cm^2$) unlösliches Material, was auf Vernetzung zurückzuführen ist.

## Patentansprüche

### Patentansprüche für folgende Vertragsstaaten : DE, FR, GB

**1.** Strahlungsempfindliches Gemisch, im wesentlichen bestehend aus

(a) einem in Wasser unlöslichen Bindemittel oder Bindemittelgemisch und
(b) einer bei Bestrahlung eine starke Säure bildenden Verbindung,

dadurch gekennzeichnet, daß Komponente (a) ein phenolisches Harz ist, dessen phenolische Hydroxylgruppen zu 5 bis 100 % ersetzt sind durch Gruppen der allgemeinen Formel (IB)

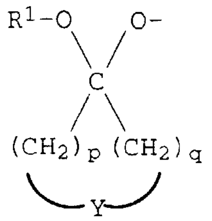

(IB),

worin $R^1$ ein geradkettiger oder verzweigter Alkylrest mit 1 bis 16 C-Atomen, ein Cycloalkylrest mit 5 bis 16 C-Atomen, ein Oxaalkyl-, Thiaalkyl-, Azaalkylrest mit bis zu 8 Sauerstoff-, Schwefel- oder Stickstoffatomen und bis zu 16 C-Atomen, Y = $(CH_2)$, O, S, $SO_2$ oder $NR^2$ mit $R^2$ = Alkyl, Aryl, substituiertes Aryl mit bis zu 16 C-Atomen, p = 1 bis 6, q = 1 bis 6 bedeuten, und Komponente (b) ein Sulfoniumsalz der Formel (IV) ist

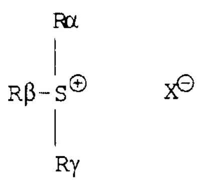

(IV)

worin Rα, Rβ und Rγ untereinander gleich oder verschieden sind und für Alkyl mit 1 bis 3 C-Atomen, Aryl, substituiertes Aryl oder Aralkyl stehen, jedoch mindestens einer dieser Reste eine Hydroxyphenylrest ist, und $X^{\ominus}$ = $ClO_4^{\ominus}$, $ASF_6^{\ominus}$, $SbF_6^{\ominus}$, $PF_6^{\ominus}$, $BF_4^{\ominus}$ und oder $CF_3SO_3^{\ominus}$ ist.

**2.** Strahlungsempfindliches Gemisch, im wesentlichen bestehend aus

a) einem in Wasser unlöslichem Bindemittel oder Bindemittelgemisch und

b) einer bei Bestrahlung eine starke Säure bildenden Verbindung,

dadurch gekennzeichnet, daß Komponente (a) ein phenolisches Harz ist, dessen phenolische Hydroxylgruppen zu 5 bis 100 % ersetzt sind durch Gruppierungen der allgemeinen Formel (IA)

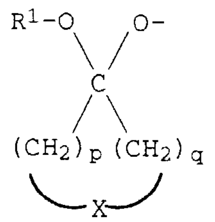

(IA),

worin $R^1$ ein geradkettiger oder verzweigter Alkylrest mit 1 bis 16 C-Atomen, ein Cycloalkylrest mit 5 bis 16 C-Atomen, Oxaalkyl-, Thiaalkyl- oder azaalkylrest mit bis zu 8 Sauerstoff-, Schwefel- oder Stickstoffatomen und bis zu 16 C-Atomen, X = 0, S, $SO_2$ oder $NR^2$ mit $R^2$ = Alkyl, Aryl, Aralkyl mit bis zu 16 C-Atomen, p = 1 bis 6 und q = 1 bis 6 bedeuten.

**3.** Strahlungsempfindliches Gemisch nach Anspruch 1 oder 2, dadurch gekennzeichnet, daß als Komponente (a) Poly- (p-hydroxistyrol) oder Poly- (p-hydroxy-α-methylstyrol) mit mittleren Molekulargewichten $\overline{M}_n$ zwischen 200 und 200 000 eingesetzt wird, wobei 10 bis 80 % der phenolischen Hydroxylgruppen durch die dort angegebenen Gruppierungen der Formel (IA) bzw. (IB) ersetzt sind.

**4.** Strahlungsempfindliches Gemisch nach einem der vorhergehenden Ansprüche, dadurch gekennzeichnet, daß Komponente (a) Gruppierungen (II) und (III) enthält, worin R' für H oder $CH_3$ und X für O, S oder $SO_2$ steht.

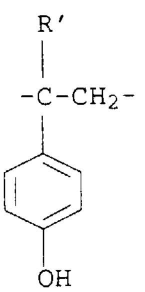

(II)

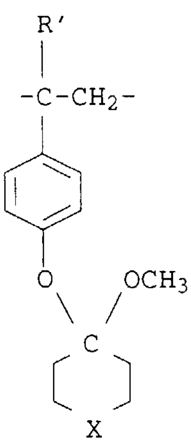

(III)

**5.** Strahlungsempfindliches Gemisch nach Anspruch 4, dadurch gekennzeichnet, daß die Komponente (a) nur Struktureinheiten (II) und (III) im Verhältnis 1:10 bis 10:1 enthält.

**6.** Strahlungsempfindliches Gemisch nach einem der vorhergehenden Ansprüche, dadurch gekennzeichnet, daß als Komponente (a) ein Umsetzungsprodukt von Poly-(p-hydroxystyrol) mit 4-Methoxy-5,6-dihydro-2*H*-pyran verwendet wird.

**7.** Strahlungsempfindliches Gemisch nach einem der vorhergehenden Ansprüche, dadurch gekennzeichnet, daß Komponente (a) in einer Menge von 80 bis 99 Gew.-% und Komponente (b) in einer Menge von 1 bis 20 Gew.-%, bezogen auf die Summe der Komponenten (a) und (b), enthalten sind.

**8.** Strahlungsempfindliches Gemisch nach einem der vorhergehenden Ansprüche, dadurch gekennzeichnet, daß es zusätzlich einen Sensibilisator enthält, der Strahlung absorbiert und auf Komponente (b) überträgt.

9. Strahlungsempfindliches Gemisch nach einem der vorhergehenden Ansprüche, dadurch gekennzeichnet, daß es als Komponente (b) ein Hydroxyphenyldimethyl-sulfoniumsalz enthält.

10. Strahlungsempfindliches Gemisch nach einem der Ansprüche 1 bis 8, dadurch gekennzeichnet, daß es als Komponente (b) Tris(4-hydroxyphenyl-sulfoniumsalz) enthält.

11. Verfahren zur Herstellung lichtempfindlicher Beschichtungsmaterialien, dadurch gekennzeichnet, daß ein strahlungsempfindliches Gemisch gemäß einem der Ansprüche 1 bis 10 eingesetzt wird.

12. Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 130°C, bildmäßiges Belichten, gegebenenfalls Erhitzen auf Temperaturen von 40 bis 160°C, und Entwickeln mit einer wäßrig-alkalischen Lösung, dadurch gekennzeichnet, daß ein strahlungsempfindliches Gemisch nach einem der Ansprüche 1 bis 10 eingesetzt wird.

**Patentansprüche für folgende Vertragsstaaten : BE, IT, NL**

1. Strahlungsempfindliches Gemisch, im wesentlichen bestehend aus

(a) einem in Wasser unlöslichen Bindemittel oder Bindemittelgemisch und
(b) einer bei Bestrahlung eine starke Säure bildende Verbindung,

dadurch gekennzeichnet, daß Komponente (a) ein phenolisches Harz ist, dessen phenolische Hydroxylgruppen zu 5 bis 100 % durch Gruppierungen der allgemeinen Formel (I)

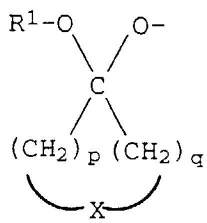

(I),

worin $R^1$ ein geradkettiger oder verzweigter Alkylrest mit 1 bis 16 Kohlenstoffatomen, ein Cycloalkylrest mit 5 bis 16 Kohlenstoffatomen, Oxaalkyl-, Thiaalkyl-, Azaalkylreste mit bis zu 8 Sauerstoff-, Schwefel- oder Stickstoffatomen und bis zu 16 Kohlenstoffatomen, X = $CH_2$, O, S, $SO_2$, $NR^2$ mit $R^2$ = Alkyl, Aryl, substituiertes Aryl, Aralkyl mit bis zu 16 Kohlenstoffatomen, p = 1 bis 6, q = 1 bis 6 bedeuten.

2. Strahlungsempfindliches Gemisch nach Anspruch 1, dadurch gekennzeichnet, daß als Komponente (a) Poly-(p-hydroxystyrol) oder Poly-(p-hydroxy-α-methylstyrol) mit mittleren Molekulargewichten $\overline{M}_n$ zwischen 200 und 200 000 eingesetzt wird, wobei 10 bis 80 % der phenolischen Hydroxylgruppen durch Gruppierungen der allgemeinen Formel (I) ersetzt sind.

3. Strahlungsempfindliches Gemisch nach einem der vorhergehenden Ansprüche, dadurch gekennzeichnet, daß Komponente (a) Gruppierungen (II) und (III) enthält, worin R' für H oder $CH_3$ und X für O, S oder $SO_2$ steht.

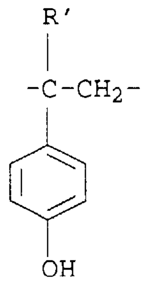

(II)

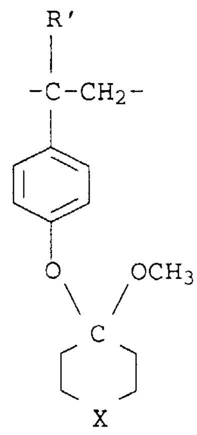

(III)

4. Strahlungsempfindliches Gemisch nach Anspruch 3, dadurch gekennzeichnet, daß die Komponente (a) nur Struktureinheiten (II) und (III) im Verhältnis 1:10 bis 10:1 enthält.

5. Strahlungsempfindliches Gemisch nach einem der Ansprüche 1 bis 3, dadurch gekennzeichnet, daß als Komponente (a) ein Umsetzungsprodukt von Poly-(p-hydroxystyrol) mit 4-Methoxy-5,6-dihydro-2*H*-pyran verwendet wird.

6. Strahlungsempfindliches Gemisch nach einem der vorhergehenden Ansprüche, dadurch gekennzeichnet, daß als Komponente (b) ein Sulfonium- oder Jodoniumsalz der allgemeinen Formeln (IV) oder (V)

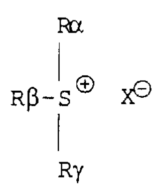

(IV)

bzw.

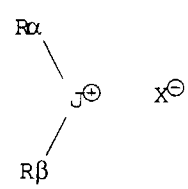

(V)

eingesetzt wird, worin Rα, Rβ und Rγ untereinander gleich oder verschieden sind und für Alkyl mit 1 bis 3 Kohlenstoffatomen, Aryl, substituiertes Aryl oder Aralkyl stehen und $X^{\ominus}$ = $ClO_4^{\ominus}$ , $AsF_6^{\ominus}$, $SbF_6^{\ominus}$, $PF_6^{\ominus}$, $BF_4^{\ominus}$ und/oder $CF_3SO_3^{\ominus}$ ist

7. Strahlungsempfindliches Gemisch nach Anspruch 6, dadurch gekennzeichnet, daß mindestens einer der Reste Rα, Rβ und Ry für einen Rest der allgemeinen Formel (VI)

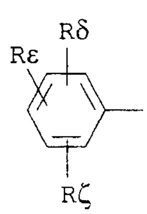

(VI)

steht, worin $R^{\delta}$, $R^{\varepsilon}$ und $R^{\zeta}$ untereinander gleich oder verschieden sind und für H, OH, Halogen, Alkyl oder Alkoxy mit jeweils 1 bis 4 Kohlenstoffatomen stehen.

8. Strahlungsempfindliches Gemisch nach einem der Ansprüche 1 bis 5, dadurch gekennzeichnet, daß als Komponente (b) ein Sulfoniumsalz der allgemeinen Formel (VII) eingesetzt wird

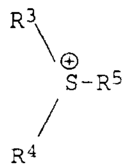

$X^{\ominus}$ (VII)

worin $R^3$, $R^4$ und $R^5$ untereinander gleich oder verschieden sind und für aliphatische und/oder aromatische Reste, die gegebenenfalls Heteroatome enthalten, stehen oder zwei der Reste $R^3$ bis $R^5$ miteinander zu einem Ring verknüpft sind, mit der Maßgabe, daß mindestens einer der Reste $R^3$ bis $R^5$ mindestens eine durch Säure spaltbare Gruppierung enthält, wobei einer der Reste $R^3$ bis $R^5$ mit einem oder mehreren weiteren Sulfoniumsalzresten, gegebenenfalls über durch Säure abspaltbare Gruppierungen, verknüpft sein kann, und $X^{\ominus}$ ein nichtnukleophiles Gegenion bedeutet.

9. Strahlungsempfindliches Gemisch nach einem der Ansprüche 1 bis 5, dadurch gekennzeichnet, daß als Komponente (b) ein Sulfonsäureester enthalten ist.

10. Strahlungsempfindliches Gemisch nach einem der Ansprüche 1 bis 5, dadurch gekennzeichnet, daß als Komponente (b) ein Alkylsulfonsäureester einer Verbindung mit mindestens zwei phenolischen Hydroxylgruppen enthalten ist.

11. Strahlungsempfindliches Gemisch nach einem der Ansprüche 1 bis 5, dadurch gekennzeichnet, daß als Komponente (b) ein Disulfon enthalten ist.

12. Strahlungsempfindliches Gemisch nach einem der vorhergehenden Ansprüche, dadurch gekennzeichnet, daß Komponente (a) in einer Menge von 80 bis 99 Gew.-% und Komponente (b) in einer Menge von 1 bis 20 Gew.-%, bezogen auf die Summe der Komponenten (a) und (b), enthalten sind.

13. Strahlungsempfindliches Gemisch nach einem der vorhergehenden Ansprüche, dadurch gekennzeichnet, daß es zusätzlich einen Sensibilisator enthält, der Strahlung absorbiert und auf Komponente (b) überträgt.

14. Verfahren zur Herstellung lichtempfindlicher Beschichtungsmaterialien, dadurch gekennzeichnet, daß ein strahlungsempfindliches Gemisch gemäß einem der Ansprüche 1 bis 13 eingesetzt wird.

15. Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 130°C, bildmäßiges Belichten, gegebenenfalls Erhitzen auf Temperaturen von 40 bis 1600C, und Entwickeln mit einer wäßrig-alkalischen Lösung, dadurch gekennzeichnet, daß ein strahlungsempfindliches Gemisch nach einem der Ansprüche 1 bis 13 eingesetzt wird.

**Claims**

**Claims for the following Contracting States : DE, FR, GB**

1. A radiation-sensitive mixture, essentially consisting of

   (a) a water-insoluble binder or binder mixture and
   (b) a compound which forms a strong acid on exposure to radiation,

wherein component (a) is a phenolic resin in which from 5 to 100% of the phenolic hydroxyl groups have been replaced with groups of the formula (IB)

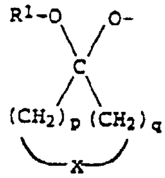

(IB)

where $R^1$ is straight-chain or branched alkyl of 1 to 16 carbon atoms, cycloalkyl of 5 to 16 carbon atoms or an oxaalkyl, thiaalkyl or azaalkyl radical having up to 8 oxygen, sulfur or nitrogen atoms and up to 16 carbon atoms, Y is $(CH_2)$, O, S, $SO_2$ or $NR^2$, $R^2$ is alkyl, aryl or substituted aryl of up to 16 carbon atoms, p is from 1 to 6 and q is from 1 to 6,
and component (b) is a sulfonium salt of the formula (IV)

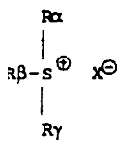

(IV)

where Rα, Rβ and Rγ are identical or different and are each alkyl of 1 to 3 carbon atoms, aryl, substituted aryl or aralkyl, but at least one of these radicals is hydroxyphenyl, and $X^{\ominus}$ is $ClO_4^{\ominus}$, $AsF_6^{\ominus}$, $SbF_6^{\ominus}$, $PF_6^{\ominus}$, $BF_4^{\ominus}$ and/or $CF_3SO_3^{\ominus}$.

**2.** A radiation-sensitive mixture, essentially consisting of

a) a water-insoluble binder or binder mixture and
b) a compound which forms a strong acid on exposure to radiation,

wherein component (a) is a phenolic resin in which from 5 to 100% of the phenolic hydroxyl groups have been replaced with groups of the formula (IA)

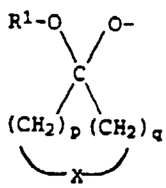

(IA)

where $R^1$ is straight-chain or branched alkyl of 1 to 16 carbon atoms, cycloalkyl of 5 to 16 carbon atoms or an oxaalkyl, thiaalkyl or azaalkyl radical of up to 8 oxygen, sulfur or nitrogen atoms and up to 16 carbon atoms, X is O, S, $SO_2$ or $NR^2$, $R^2$ is alkyl, aryl or aralkyl of up to 16 carbon atoms, p is from 1 to 6 and q is from 1 to 6.

**3.** A radiation-sensitive mixture as claimed in claim 1 or 2, wherein poly(p-hydroxystyrene) or poly(p-hydroxy-α-methylstyrene) having average molecular weights $\overline{M}_n$ of from 200 to 200,000 is used as component (a), from 10 to 80% of the phenolic hydroxyl groups having been replaced with the groups of the formula (IA) or (IB) given there.

**4.** A radiation-sensitive mixture as claimed in any of the preceding claims, wherein component (a) contains groups (II) and (III) where R' is H or $CH_3$ and X is O, S or $SO_2$.

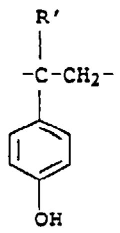

(II)

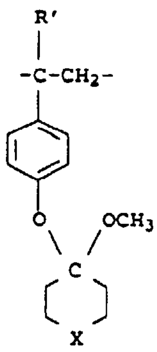

(III)

5. A radiation-sensitive mixture as claimed in claim 4, wherein the component (a) contains only structural units (II) and (III) in a ratio of from 1:10 to 10:1.

6. A radiation-sensitive mixture as claimed in any of the preceding claims, wherein a reaction product of poly(p-hydroxystyrene) with 4-methoxy-5,6-dihydro-2H-pyran is used as component (a).

7. A radiation-sensitive mixture as claimed in any of the preceding claims, wherein component (a) is present in an amount of from 80 to 99% by weight and component (b) is present in an amount of from 1 to 20% by weight, based on the sum of the components (a) and (b).

8. A radiation-sensitive mixture as claimed in any of the preceding claims, which additionally contains a sensitizer which absorbs radiation and transfers it to component (b).

9. A radiation-sensitive mixture as claimed in any of the preceding claims, which contains a hydroxyphenyldimethylsulfonium salt as component (b).

10. A radiation-sensitive mixture as claimed in any of claims 1 to 8, which contains tris(4-hydroxyphenyl)sulfonium salt as component (b).

11. A process for the preparation of a photosensitive coating material, wherein a radiation-sensitive mixture as claimed in any of claims 1 to 10 is used.

12. A process for the production of relief structures by application of a radiation-sensitive mixture in a layer thickness of from 0.1 to 5 μm to a conventionally pretreated substrate, drying at from 70 to 130°C, imagewise exposure, if necessary heating to 40-160°C, and development with an aqueous alkaline solution, wherein a radiation-sensitive mixture as claimed in any of claims 1 to 10 is used.

**Claims for the following Contracting States : BE, IT, NL**

1. A radiation-sensitive mixture, essentially consisting of

(a) a water-insoluble binder or binder mixture and
(b) a compound which forms a strong acid on exposure to radiation,

wherein component (a) is a phenolic resin in which from 5 to 100% of the phenolic hydroxyl groups have been replaced with groups of the formula (I)

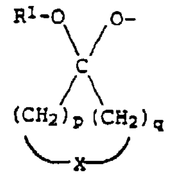

(I)

where $R^1$ is straight-chain or branched alkyl of 1 to 16 carbon atoms, cycloalkyl of 5 to 16 carbon atoms or an oxaalkyl, thiaalkyl or azaalkyl radical having up to 8 oxygen, sulfur or nitrogen atoms and up to 16 carbon atoms, X is $CH_2$, O, S, $SO_2$ or $NR^2$, $R^2$ is alkyl, aryl, substituted aryl or aralkyl of up to 16 carbon atoms, p is from 1 to 6 and q is from 1 to 6.

**2.** A radiation-sensitive mixture as claimed in claim 1, wherein poly(p-hydroxystyrene) or poly(p-hydroxy-α-methylstyrene) having average molecular weights $\overline{M}_n$ of from 200 to 200,000 is used as component (a), from 10 to 80% of the phenolic hydroxyl groups having been replaced with groups of the formula (I).

**3.** A radiation-sensitive mixture as claimed in any of the preceding claims, wherein component (a) contains groups (II) and (III) where R' is H or $CH_3$ and X is O, S or $SO_2$.

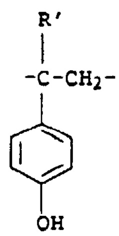

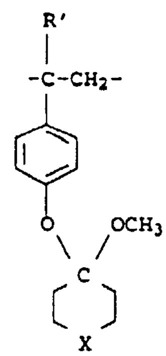

(II) (III)

**4.** A radiation-sensitive mixture as claimed in claim 3, wherein the component (a) contains only structural units (II) and (III) in a ratio of from 1:10 to 10:1.

**5.** A radiation-sensitive mixture as claimed in any of claims 1 to 3, wherein a reaction product of poly(p-hydroxystyrene) with 4-methoxy-5,6-dihydro-2H-pyran is used as component (a).

**6.** A radiation-sensitive mixture as claimed in any of the preceding claims, wherein a sulfonium or iodonium salt of the formula (IV) or (V)

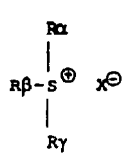

(IV)

or

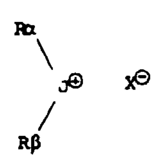

(V)

where Rα, Rβ and Rγ are identical or different and are each alkyl of 1 to 3 carbon atoms, aryl, substituted aryl or aralkyl and $X^\ominus$ is $ClO_4^\ominus$, $AsF_6^\ominus$, $SbF_6^\ominus$, $PF_6^\ominus$, $BF_4^e$ and/or $CF_3SO_3^\ominus$, is used as component (b).

**7.** A radiation-sensitive mixture as claimed in claim 6, wherein at least one of the radicals Rα, Rβ and Ry is a radical

of the formula (VI)

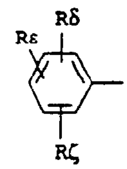

(VI)

where Rδ, Rε and Rζ are identical or different and are each H, OH, halogen, alkyl or alkoxy, each of 1 to 4 carbon atoms.

**8.** A radiation-sensitive mixture as claimed in any of claims 1 to 5, wherein a sulfonium salt of the formula (VII)

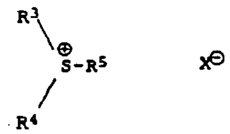

(VII)

where $R^3$, $R^4$ and $R^5$ are identical or different and are each an aliphatic and/or aromatic radical which may contain hetero atoms, or two of the radicals $R^3$ to $R^5$ are bonded to one another to form a ring, with the proviso that at least one of the radicals $R^3$ to $R^5$ contains at least one acid-cleavable group, and one of the radicals $R^3$ to $R^5$ may be bonded to one or more further sulfonium salt radicals, if necessary via acid-cleavable groups, and $X^{\ominus}$ is a nonnucleophilic counter-ion, is used as component (b).

**9.** A radiation-sensitive mixture as claimed in any of claims 1 to 5, wherein a sulfonic ester is contained as component (b).

**10.** A radiation-sensitive mixture as claimed in any of claims 1 to 5, wherein an alkylsulfonic ester of a compound having at least two phenolic hydroxyl groups is contained as component (b).

**11.** A radiation-sensitive mixture as claimed in any of claims 1 to 5, wherein a disulfone is contained as component (b).

**12.** A radiation-sensitive mixture as claimed in any of the preceding claims, wherein component (a) is present in an amount of from 80 to 99% by weight and component (b) is present in an amount of from 1 to 20% by weight, based on the sum of the components (a) and (b).

**13.** A radiation-sensitive mixture as claimed in any of the preceding claims, which additionally contains a sensitizer which absorbs radiation and transfers it to component (b).

**14.** A process for the preparation of a photosensitive coating material, wherein a radiation-sensitive mixture as claimed in any of claims 1 to 13 is used.

**15.** A process for the production of relief structures by application of a radiation-sensitive mixture in a layer thickness of from 0.1 to 5 µm to a conventionally pretreated substrate, drying at from 70 to 130°C, imagewise exposure, if necessary heating to 40-160°C, and development with an aqueous alkaline solution, wherein a radiation-sensitive mixture as claimed in any of claims 1 to 13 is used.

## Revendications

### Revendications pour les Etats contractants suivants : DE, FR, GB

**1.** Mélange sensible aux rayonnements, consistant essentiellement en

a) un liant ou mélange de liants insoluble dans l'eau, et
b) un composé formant un acide fort sous l'action du rayonnement,

caractérisé par le fait que le composant a) est une résine phénolique dont les groupes hydroxy phénoliques sont remplacés en proportions de 5 à 100 % par des groupes de formule générale IB

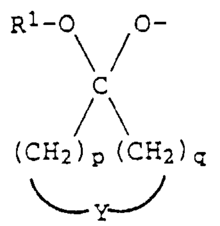

(IB),

dans laquelle $R^1$ représente un groupe alkyle à chaîne droite ou ramifiée en C1-C16, un groupe cycloalkyle en C5-C16, un groupe oxaalkyle, thiaalkyle, azaalkyle contenant jusqu'à 8 atomes d'oxygène, de soufre ou d'azote et jusqu'à 16 atomes de carbone, Y = $(CH_2)$, O, S, $SO_2$ ou $NR^2$ dans lequel $R^2$ = alkyle, aryle, aryle substitué contenant jusqu'à 16 atomes de carbone, p = 1 à 6, q = 1 à 6,
et le composant b) est un sel de sulfonium de formule IV

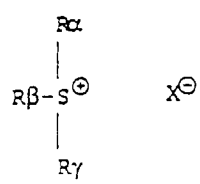

(IV)

dans laquelle Rα, Rβ et Rγ, ayant des significations identiques ou différentes, représentent chacun un groupe alkyle en C1-C3, aryle, aryle substitué ou aralkyle, sous réserve que l'un au moins de ces symboles représente un groupe hydroxyphényle, et $X^{O}$ = $Cl^{O}{}_4^{O}$, $ASF_6^{O}$, $SbF_6^{O}$, $PF_6$, $BF_4^{O}$ et/ou $CF_3SO_3O$.

**2.** Mélange sensible aux rayonnements, consistant essentiellement en

a) un liant ou mélange de liants insoluble dans l'eau et

b) un composé formant un acide fort sous l'action du rayonnement,

caractérisé par le fait que le composant a) est une résine phénolique dont les groupes hydroxy phénoliques sont remplacés en proportions de 5 à 100 % par des groupements de formule générale IA

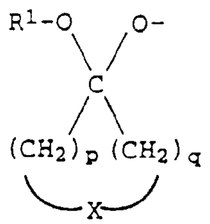

(IA),

dans laquelle $R^1$ représente un groupe alkyle à chaîne droite ou ramifiée en C1-C16, un groupe cycloalkyle en C5-C16, un groupe oxaalkyle, thiaalkyle ou azaalkyle contenant jusqu'à 8 atomes d'oxygène, de soufre ou d'azote et jusqu'à 16 atomes de carbone, X = O, S, $SO_2$ ou $NR^2$ avec $R^2$ = alkyle, aryle, aralkyle contenant jusqu'à 16 atomes de carbone, p = 1 à 6 et q = 1 à 6.

**3.** Mélange sensible aux rayonnements selon la revendication 1 ou 2, caractérisé par le fait que l'on utilise en tant que composant a) un poly(p-hydroxystyrène) ou un poly-(p-hydroxy-alpha-méthylstyrène) de poids moléculaire moyen $\overline{M}_n$ compris entre 200 et 200 000, 10 à 80 % des groupes hydroxy phénoliques étant remplacés par les groupements de formule IA ou IB ci-dessus.

**4.** Mélange sensible aux rayonnements selon l'une des revendications qui précèdent, caractérisé par le fait que le composant a) contient des groupements II et III dans lesquels R' représente H ou $CH_3$ et X représente O, S ou $SO_2$ :

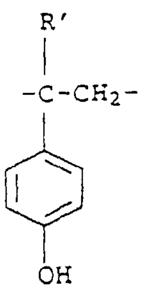

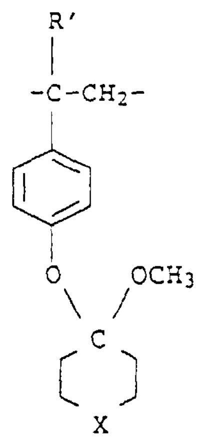

(II) (III)

**5.** Mélange sensible aux rayonnements selon la revendication 4, caractérisé par le fait que le composant a) ne contient que des motifs de structure II et III dans des proportions relatives de 1 : 10 à 10 : 1.

**6.** Mélange sensible aux rayonnements selon l'une des revendications qui précèdent, caractérisé par le fait que l'on a utilisé en tant que composant a) un produit de réaction d'un poly-(p-hydroxystyrène) et du 4-méthoxy-5,6-dihydro-2H-pyranne.

**7.** Mélange sensible aux rayonnements selon l'une des revendications qui précèdent, caractérisé par le fait que le composant a) est contenu en quantité de 80 à 99 % en poids et le composant b) en quantité de 1 à 20 % en poids par rapport à la somme des composants a) et b).

**8.** Mélange sensible aux rayonnements selon l'une des revendications qui précèdent, caractérisé par le fait qu'il contient en outre un sensibilisant qui absorbe le rayonnement et le transfère au composant b).

**9.** Mélange sensible aux rayonnements selon l'une des revendications qui précèdent, caractérisé par le fait qu'il contient en tant que composant b) un sel d'hydroxyphényldiméthylsulfonium.

**10.** Mélange sensible aux rayonnements selon l'une des revendications 1 à 8, caractérisé par le fait qu'il contient en tant que composant b) un sel de tris-(4-hydroxyphénylsulfonium).

**11.** Procédé pour former des matières de revêtement photosensibles, caractérisé par le fait que l'on utilise un mélange sensible aux rayonnements selon l'une des revendications 1 à 10.

**12.** Procédé pour former des structures en relief par application d'un mélange sensible aux rayonnements à une épaisseur de couche de 0,1 à 5 µm sur un support traité au préalable de la manière habituelle, séchage à des températures de 70 à 130°C, exposition à la lumière avec formation d'une image, le cas échéant chauffage à des températures de 40 à 160°C et développement à l'aide d'une solution aqueuse alcaline, caractérisé par le fait que l'on utilise un mélange sensible aux rayonnements selon l'une des revendications 1 à 10.

**Revendications pour les Etats contractants suivants : BE, IT, NL**

**1.** Mélange sensible aux rayonnements, consistant essentiellement en

(a) un liant ou un mélange de liants insoluble dans l'eau
et
(b) un composé formant un acide fort sous l'effet d'un rayonnement,

caractérisé par le fait que le composé (a) est une résine phénolique, dont les groupes hydroxyle phénoliques sont remplacés dans la proportion de 5 à 100% par des groupements de formule générale (I)

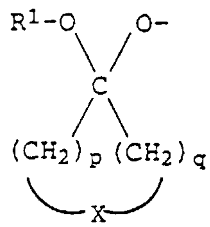

(I),

où $R^1$ est un reste alkyle en chaîne droite ou ramifiée ayant 1 à 16 atomes de carbone, un reste cycloalkyle ayant 5 à 16 atomes de carbone, des restes oxaalkyle, thiaalkyle, azaalkyle ayant jusqu'à 8 atomes d'oxygène, de soufre ou d'azote et jusqu'à 16 atomes de carbone, X = $CH_2$, O, S, $SO_2$, $NR^2$ avec $R^2$ = alkyle, aryle, aryle substitué, aralkyle ayant jusqu'à 16 atomes de carbone, p = 1 à 6, q = 1 à 6.

**2.** Mélange sensible aux rayonnements selon la revendication 1, caractérisé par le fait qu'on utilise comme composant (a) du poly-(p-hydroxystyrène) ou du poly(p-hydrdoxy-α-méthylstyrène) ayant des masses moléculaires moyennes $\overline{M}_n$ comprises entre 200 et 200000, tandis que 10 à 80% des groupes hydroxyle phénoliques sont remplacés par des groupements de formule générale (I).

**3.** Mélange sensible aux rayonnements selon l'une des revendications précédentes, caractérisé par le fait que le composant (a) contient des groupements (II) et (III) où R' désigne H ou $CH_3$ et X représente O, S ou $SO_2$.

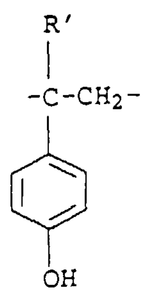

(II)

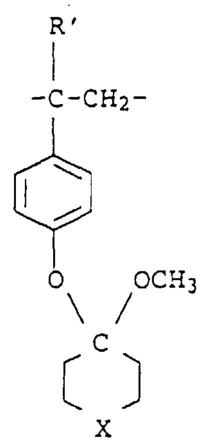

(III)

**4.** Mélange sensible aux rayonnements selon la revendication 3, caractérisé par le fait que le composant (a) contient seulement des unités structurales (II) et (III) dans la proportion de 1:10 à 10:1.

**5.** Mélange sensible aux rayonnements selon l'une des revendications 1 à 3, caractérisé par le fait que l'on utilise comme composant (a) un produit de réaction de poly-(p-hydroxystyrène) avec du 4-méthoxy-5,6-dihydro-2H-pyranne.

**6.** Mélange sensible aux rayonnements selon l'une des revendications précédentes, caractérisé par le fait qu'on utilise comme composant (b) un sel de sulfonium ou d'iodonium de formules générales (IV) ou (V)

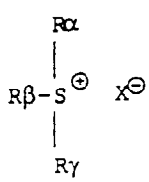

(IV)

ou

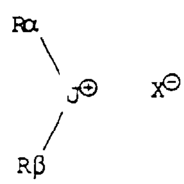

(V)

où Rα, Rβ et Rγ sont identiques entre eux ou différents et désignent un groupe alkyle ayant 1 à 3 atomes de carbone, aryle, aryle substitué ou aralkyle et $X^{\ominus} = ClO_4^{\ominus}$, $AsF_6^{\ominus}$, $SbF_6^{\ominus}$ , $PF_6^{\ominus}$, $BF_4^{\ominus}$ et/ou $CF_3SO_3^{\ominus}$.

**7.** Mélange sensible aux rayonnements selon la revendication 6, caractérisé par le fait qu'au moins un des restes Rα, Rβ et Rγ représente un reste de formule générale (VI)

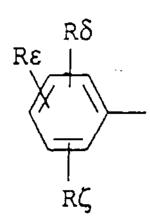

(VI)

où Rδ, Rε et Rζ sont identiques entre eux ou différents et représentent H, OH, un halogène, un alkyle ou un alcoxy ayant dans chaque cas 1 à 4 atomes de carbone.

**8.** Mélange sensible aux rayonnements selon l'une des revendications 1 à 5, caractérisé par le fait qu'on utilise comme composant (b) un sel de sulfonium de formule générale (VII)

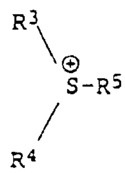 $X^{\ominus}$ (VII)

où $R^3$, $R^4$ et $R^5$ sont identiques entre eux ou différents et représentent des restes aliphatiques et/ou aromatiques qui contiennent éventuellement des hétéroatomes, ou bien deux des restes $R^3$ à $R^5$ sont liés entre eux pour former un cycle, avec pour condition qu'au moins un des restes $R^3$ à $R^5$ contient au moins un groupement éliminable par un acide, tandis que l'un des restes $R^3$ à $R^5$ peut être relié avec un ou plusieurs autres restes de sel de sulfonium, éventuellement par l'intermédiaire de groupements éliminables par un acide, et $X^{\ominus}$ représente un contre-ion non-nucléophile.

**9.** Mélange sensible aux rayonnements selon l'une des revendications 1 à 5, caractérisé par le fait qu'il contient comme composant (b) un ester d'acide sulfonique.

**10.** Mélange sensible aux rayonnements selon l'une des revendications 1 à 5, caractérisé par le fait qu'il contient comme composant (b) un ester d'acide alkylsulfonique d'un composé ayant au moins deux groupes hydroxyle phénoliques.

**11.** Mélange sensible aux rayonnements selon l'une des revendications 1 à 5, caractérisé par le fait qu'il contient comme composant (b) une disulfone.

**12.** Mélange sensible aux rayonnements selon l'une des revendications précédentes, caractérisé par le fait que le composant (a) est contenu en une quantité de 80 à 99% en poids et le composant (b) est contenu en une quantité de 1 à 20% en poids, par rapport à la somme des composants (a) et (b).

**13.** Mélange sensible aux rayonnements selon l'une des revendications précédentes, caractérisé par le fait qu'il contient en outre un sensibilisant, qui absorbe le rayonnement et le transmet au composant (b).

**14.** Procédé pour la préparation de matériaux de revêtement sensibles à la lumière, caractérisé par le fait qu'on utilise un mélange sensible aux rayonnements selon l'une des revendications 1 à 13.

**15.** Procédé pour la préparation de structures en relief par dépôt d'un mélange sensible aux rayonnements dans une épaisseur de couche de 0,1 à 5 µm sur un substrat prétraité de manière classique, séchage à des températures de 70 à 130°C, éclairage selon une image, éventuellement chauffage à des températures de 40 à 160°C, et développement avec une solution aqueuse alcaline, caractérisé par le fait qu'on utilise un mélange sensible aux rayonnements selon l'une des revendications 1 à 13.